(19) Europäisches Patentamt
European Patent Office
Office européen des brevets

(11) Veröffentlichungsnummer: **0 513 781 A1**

# (12) EUROPÄISCHE PATENTANMELDUNG

(21) Anmeldenummer: **92108142.8**

(51) Int. Cl.[5]: **C08F 2/50**, G03F 7/029

(22) Anmeldetag: **14.05.92**

(30) Priorität: **16.05.91 DE 4115950**

(43) Veröffentlichungstag der Anmeldung:
**19.11.92 Patentblatt 92/47**

(84) Benannte Vertragsstaaten:
**PT**

(71) Anmelder: **Herberts Gesellschaft mit beschränkter Haftung**
**Christbusch 25**
**W-5600 Wuppertal 2(DE)**

(72) Erfinder: **Bastian, Udo, Dr.**
**Backhausfeld 25**
**W-4030 Ratingen 1(DE)**
Erfinder: **Schubert, Bernd, Dr.**
**Goerdelerstrasse 1**
**W-5600 Wuppertal 11(DE)**

(74) Vertreter: **Türk, Gille, Hrabal, Leifert**
**Brucknerstrasse 20**
**W-4000 Düsseldorf 13(DE)**

## (54) Flüssige Gemische von Photoinitiatoren, Verfahren zu deren Herstellung und deren Verwendung.

(57) 2.1 Photoinitiatoren vom Acylphosphanoxid-Typ sind in strahlenhärtbaren Massen schlecht löslich. Es sollen daher lösliche Modifikationen bereitgestellt werden.

2.2 Photoinitiatoren vom Acylphosphanoxid-Typ werden durch Zusatz von einem oder mehreren bei Raumtemperatur festen oder flüssigen Photoinitiatoren und gegebenenfalls Erwärmen verflüssigt.

2.3 Einsatz flüssiger Photoinitiatorgemische bei der Photopolymerisation.

EP 0 513 781 A1

Die Erfindung betrifft flüssige Gemische aus zwei oder mehreren Photoinitiatoren, von denen mindestens einer ein bei Raumtemperatur in fester Form vorliegender Photoinitiator vom Acylphosphanoxidtyp ist.

Strahlenhärtbare Systeme werden für verschiedene Anwendungszwecke, beispielsweise als Vergußmassen oder Beschichtungsmittel eingesetzt. Es handelt sich um Systeme, die flüssige ungesättigte Monomere oder Oligomere enthalten, denen ein Photoinitiator zugesetzt wird und die dann durch energiereiche Strahlung, beispielsweise UV-Strahlung oder Elektronenstrahlung, ausgehärtet werden können.

Es sind zahlreiche Photoinitatoren zur Photopolymerisation von strahlenhärtbaren Massen bekannt. Bei den meisten dieser Photoinitiatoren handelt es sich um Feststoffe, um Stoffe, die bei Raumtemperatur in fester Form vorliegen. Beim Einsatz in photopolymerisierbaren Massen müssen die Photoinitiatoren in diesen Massen gelöst werden. Hier ergibt sich häufig der Nachteil einer begrenzten Handhabung, da viele wirksame Photoinitiatoren in den meisten Formulierungen schlecht löslich sind und daher lange Zubereitungszeiten durch die schwierige Auflösung der Photoinitiatoren erforderlich sind. Auch ist die Auflösung bei pigmentierten und gefüllten Systemen häufig schlecht zu erkennen. Bei der Herstellung von zu härtenden Systemen erfolgt häufig ein Filtrationsvorgang vor der eigentlichen Verwendung. Hierzu ist es wichtig, daß die Photoinitiatoren vollständig aufgelöst sind. Ist dies nämlich nicht der Fall, so können Teile der Photoinitiatoren aus dem zu härtenden System entfernt werden, so daß die erforderlichen Mengen nicht mehr vorhanden sind. Insbesondere zeigen Acylphosphanoxide diese Nachteile. Acylphosphanoxide werden als Photoinitiatoren beispielsweise in EP-A-0 304 782 und in EP-A-0 413 657 beschrieben.

Die vorliegende Erfindung hat sich die Aufgabe gestellt, Photoinitiatorsysteme auf Acylphosphanoxidbasis bereitzustellen, die eine rasche homogene Auflösung in zu härtenden flüssigen Massen ermöglichen und daher leicht, rasch und in wirtschaftlicher Weise verarbeitbar sind und die vorstehend aufgezeigten Probleme nicht ergeben.

Überraschenderweise hat es sich gezeigt, daß diese Aufgabe dadurch gelöst werden kann, daß feste Acylphosphanoxide im Gemisch mit weiteren festen oder flüssigen Photoinitiatoren leicht verflüssigt werden können und in der verflüssigten Form ohne Schwierigkeiten in zu polymerisierende ungesättigte Massen homogen eingearbeitet werden können.

Gegenstand der Erfindung sind daher flüssige Gemische aus zwei oder mehreren Photoinitiatoren, von denen mindestens einer ein bei Raumtemperatur in fester Form vorliegendes Acylphosphanoxid ist, und die dadurch gekennzeichnet sind, daß sie durch Erwärmen und/oder durch Zusatz eines bei Raumtemperatur flüssigen Photoinitiators verflüssigt wurden.

Erfindungsgemäß können beispielsweise zwei, drei oder mehrere bei Raumtemperatur feste Photoinitiatoren, von denen mindestens einer ein Acylphosphonoxid ist, im Gemisch erwärmt und verflüssigt werden. Die verflüssigten Gemische können den zu polymerisierenden Massen unmittelbar zugesetzt werden und lösen sich darin sehr rasch. Es hat sich gezeigt, daß die durch Erwärmen verflüssigten Photoinitiatorgemische so stabil sind, daß sie vor dem Zusatz zu den zu polymerisierenden Massen abgekühlt werden können. Häufig sind die abgekühlten verflüssigten Gemische über längere Zeiträume stabil und verbleiben im flüssigen Zustand.

Bei der Verwendung von zwei festen oder einem festen und einem flüssigen Photoinitiator können die Mengenverhältnisse der beiden Photoinitiatoren im weiteren Bereich variieren. Bevorzugt liegen Mengen von 10 : 1 bis 1 : 10, bezogen auf das Gewicht vor, wobei besonders bevorzugte Gewichtsverhältnisse 3 : 1 bis 1 : 3 und insbesondere 1 : 1 sind. Mehrkomponentige Mischungen können in analogen Verhältnissen hergestellt werden. Beispielsweise liegt ein bevorzugtes Mischungsverhältnis für drei Komponentenmischungen bei 1 : 1 : 1, bezogen auf das Gewicht.

Bei der Herstellung der flüssigen Photoinitiatorgemische der Erfindung werden die Initiatoren in den gewünschten Anteilen in fester Form miteinander vermischt und anschließend erwärmt. Die Erwärmung erfolgt beispielsweise auf Temperaturen in der Größenordnung von 60 bis 80°C. Nach der Verflüssigung durch Erwärmen wird die Mischung durch Rühren homogenisiert. Sie bleibt dann auch bei der Abkühlung auf Raumtemperatur ausreichend lange flüssig, um dem zu polymerisierenden System zugesetzt werden zu können. Liegt in einem Gemisch ein Photoinitiator in bei Raumtemperatur flüssiger Form vor, so können ein oder mehrere andere Photoinitiatoren in diesem unter Rühren gelöst werden. Während des Rührens oder anschließend kann erwärmt werden, beispielsweise ebenfalls auf Temperaturen von 60 bis 80°C. Hierdurch wird der Mischvorgang deutlich beschleunigt. Durch anschließendes Rühren kann eine homogene Mischung hergestellt werden, die auch bei Raumtemperatur über längere Zeit flüssig bleibt.

Für die erfindungsgemäßen flüssigen Photoinitiatorgemische können ein oder mehrere durch Erwärmen verflüssigbare Acylphosphanoxide mit einem oder mehreren beliebigen durch Erwärmen verflüssigbaren festen Photoinitiatoren eingesetzt werden.

Als Acylphosphanoxid-Photoinitiatoren kommen sämtliche bekannten derartigen Photoinitiatoren infrage. Acylphosphanoxide werden in der Literatur häufig auch als Acylphosphinoxide bezeichnet. Eingesetzt

werden können Mono- und Diacylphosphanoxide, wobei auch zyklische Verbindungen dieser Art infrage kommen, wie sie in der Literatur beschrieben werden. Beispiele für erfindungsgemäß verwendbare Acylphosphanoxide werden in EP-A-0 304 782 und in EP-A-0 413 657 beschrieben. Beispiele für erfindungsgemäß einsetzbare Photoinitiatoren vom Acylphosphanoxid-Typ sind im folgenden aufgeführt. Zu diesen Beispielen gehören die bekannten Acylphosphanoxide, beispielsweise solche der Formel

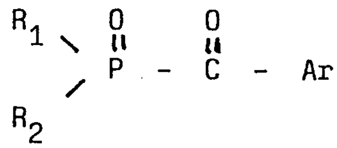

(I)

oder solche der Formel

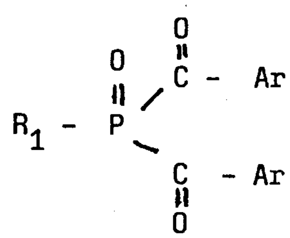

(II)

worin $R_1$, $R_2$ und Ar, die gleich oder verschieden sein können, jeweils einen aromatischen Rest darstellen, beispielsweise den Phenylrest, der jeweils einen oder mehrere Substituenten tragen kann, wie beispielsweise Alkyl mit 1 bis 4 Kohlenstoffatomen, Alkoxy mit 1 bis 4 Kohlenstoffatomen und Phenoxy. Ein spezielles Beispiel für eine Verbindung der Formel I ist das Diphenyl-2,4,6-Trimethyl-Benzoyl-Phosphanoxid.

Beispiele für Photoinitiatoren vom Acylphosphanoxidtyp in cyclischer Form die erfindungsgemäß eingesetzt werden, sind die in EP-A-0 304 782 beschriebenen Acylphosphorinoxide. Es handelt sich hierbei um Verbindungen der allgemeinen Formel

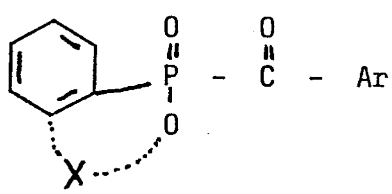

III.

worin X eine zum Ringschluß befähigte Gruppe ist und an die 2,3,4,5- oder 6-Stellung des Phenylrests gebunden sein kann. Beispielsweise handelt es sich bei X um eine Alkylengruppe mit 2 bis 4 Kohlenstoffatomen, bevorzugt mit 2 Kohlenstoffatomen oder um eine Phenylengruppe, besonders bevorzugt eine o-Phenylengruppe. Die Gruppe X kann einen oder mehrere Substituenten tragen, beispielsweise Halogen, wie Chlor oder Brom, Alkyl oder Alkoxy mit jeweils 1 bis 6 Kohlenstoffatomen. Auch die in der vorstehenden Formel III aufgeführte Phenylgruppe kann einen oder mehreren Substituenten aufweisen, wie Halogen, insbesondere Chlor und/oder Brom, Alkyl oder Alkoxy mit jeweils 1 bis 6 Kohlenstoffatomen. Ar stellt einen Kohlenwasserstoffrest mit 6 bis 10 Kohlenstoffatomen dar, insbesondere den Phenylrest. Dieser Rest kann substituiert sein durch ein oder mehrere Substituenten, beispielsweise Halogenatome, wie Chlor oder Brom, Alkyl oder Alkoxy mit jeweils 1 bis 6 Kohlenstoffatomen oder Phenoxy.

Besonders bevorzugte Verbindungen der vorstehenden allgemeinen Formel III sind die nachstehend angegebenen 6-Acyl-(6H)-dibenz[c,e][1,2]-oxaphosphorin-6-oxide der allgemeinen Formel

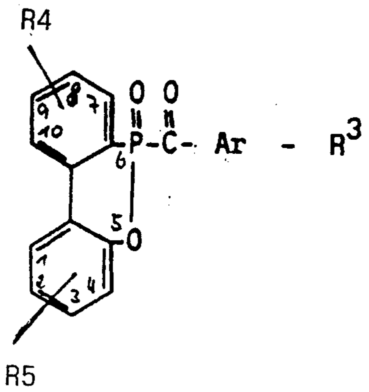

IV.

worin jeder der Reste $R^3$, $R^4$ und $R^5$ ein- oder mehrfach enthalten sein kann und $R^3$, $R^4$ und $R^5$ Halogen mit einer Ordnungszahl von 9 bis 35, Alkyl oder Alkoxy mit jeweils 1 bis 8, vorzugsweise 1 bis 4 Kohlenstoffatomen und Ar einen aromatischen Kohlenwasserstoffrest mit 6 bis 10 Kohlenstoffatomen bedeuten. Für die vorstehend eingegebenen Substituentenbedeutungen sind als Alkylgruppen Methyl und Ethyl und als Alkoxygruppen Methoxy besonders bevorzugt. In vielen Fällen enthalten die Verbindungen wenigstens ein Chloratom, zweckmäßig jedoch höchstens 2 Chloratome, von denen wiederum zweckmäßig mindestens eines $R^3$ darstellt. Zweckmäßig ist jeder Substituent $R^4$ und $R^5$ nur höchstens einmal vorhanden, insbesondere als $R^5$ und bevorzugt gar nicht vorhanden. Beispiele sind 6-(3-Chlor-benzoyl)- und das 6-(2,6-Dichlor-benzoyl)-(6H)-dibenz[c,e][1,2]-oxaphosphorin-6-oxid genannt, ferner das 6-Benzoyl-(6H)-2- bzw. -4-chlor-, 6-(2- bzw. 3-Methylbenzoyl)-(6H)-2- bzw. -4-chlor, 6-(2,4- bzw. 2,6- bzw. 3,4- bzw. 3,5-Dimethylbenzoyl)-(6H)-2- bzw. -4-chlor-, das 6-(2,4,6-Trimethylbenzoyl)-4-chlor-, das 6-, 2- bzw. 3-Chlorbenzoyl)-(6H)-2- bzw. - 4chlor- und das 6-(2,6-Dimethoxy-benzoyl)-(6H)-2- bzw. -4-chlor-dibenz-[c,e][1,2]-oxaphosphorin-6-oxid.

Weitere Beispiele von bei Raumtemperatur festen Photoinitiatoren vom Acylphosphanoxid-Typ, die für die vorliegende Erfindung besonders geeignet sind, sind in der EP-A-07086 und in den veröffentlichten DE-A-29 09 994 und DE-A-29 09 992 beschrieben.

Weitere Beispiele für verwendbare Photoinitiatoren vom Acylphosphanoxid-Typ sind in EP-A-0 413 657 beschrieben. Es handelt sich dabei um vorwiegend aliphatische und zykloaliphatische Mono- und Diacylphosphanoxide. Besonders bevorzugte Beispiele der dort beschriebenen, erfindungsgemäß einsetzbaren Photoinitiatoren vom Acylphosphanoxid-Typ haben die folgenden Formeln

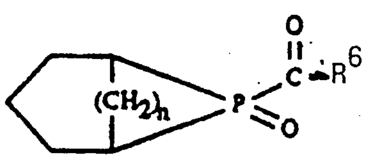

V.

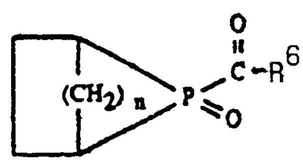

VI.

worin $R^6$ einen gegebenenfalls substituierten Phenylrest darstellt, beispielsweise den 2,4,6-Trimethylphenylrest oder den 2,6-Dimethoxyphenylrest.

Erfindungsgemäß hat es sich gezeigt, daß der angestrebte Verflüssigungseffekt günstig erzielt werden kann, wenn zwei oder mehrere Photoinitiatoren vom Acylphosphanoxid-Typ gemischt und gegebenenfalls erwärmt werden. Es ist jedoch auch die Mischung mit Photoinitiatoren anderer Typen geeignet.

Bevorzugte weitere Mischungskomponenten sind Initiatoren vom Acetophenon- und Benzophenon-Typ sowie z.B. 2-Hydroxy-2-methyl-1-phenyl-propan-1-on,1-Hydroxy-cyclohexyl-phenylketon, Diethoxyacetophenon, Benzophenon sowie vom Thioxanthon-Typ und vom Ketal-Typ, wie z.B. Benzyldimethylketal. Diese können einzeln oder in Kombination, sowie auch in Kombination mit mehreren Photoinitiatoren vom Acylphosphanoxid-Typ eingesetzt werden.

Bei den vorstehend genannten Diethoxyacetophenon und 2-Hydroxy-2-methyl-1-phenyl-propan-1-on handelt es sich um bei Raumtemperatur flüssige Photoinitiatoren, die als flüssige Komponente eingesetzt werden können. Wenn diese flüssige Komponente im Überschuß vorliegt, ist ein Erwärmen eines Gemischs mit einem oder mehreren festen Photoinitiatoren nicht notwendig, bei einem Überschuß des oder der festen

Photoinitiatoren, beispielsweise vom TPO-Typ, ist es günstig, das flüssige Gemisch unter Erwärmen herzustellen.

Die erfindungsgemäß bereitgestellten flüssigen Photoinitiatorgemische können leicht in sämtlichen üblichen durch energiereiche Strahlung härtbaren Massen, beispielsweise durch energiereiche Strahlung härtbaren Bindemittelsystemen homogen gelöst werden. Es sind alle durch energiereiche Strahlung härtbaren Massen geeignet, wobei diese sowohl in pigmentierter als auch in unpigmentierter Form eingesetzt werden können.

Bei den härtbaren Massen handelt es sich um übliche durch UV-Strahlung oder energiereiche Strahlung härtbare Massen, wie beispielsweise Überzugsmittel, die dem Fachmann geläufig sind. Sie unterliegen keiner Einschränkung.

Beispiele sind übliche UV-härtbare Massen, z.B. Lacke auf der Basis von Monomeren, Oligomeren, Polymeren, Copolymeren oder Kombinationen davon, mit einer oder mehreren olefinischen Doppelbindungen, wie beispielsweise Acrylsäure- und Methacrylsäureester; Beispiele hierfür sind Butyl(meth)acrylat, Dipropylenglykoldi(meth)acrylat, Trimethylolpropantri(meth)acrylat. Der hier verwendete Ausdruck (Meth)-acrylat bedeutet Acrylate und/oder Methacrylate. Beispiele für Oligomere oder Prepolymere sind (Meth)-acrylfunktionelle(meth)acrylcopolymere, Epoxidharz(meth)acrylate z.B. Umsetzungsprodukte aus 2 Mol-(meth)acrylsäure und handelsüblichen Epoxidharzen, wie z.B. Epicote 828, Polyester(meth)acrylate, Polyether(meth)acrylate, Urethan(meth)acrylate, Amin(meth)acrylate, ungesättigte Polyester, ungesättigte Polyurethane, Silicon(meth)acrylate oder Kombinationen davon. Beispiele für derartige härtbare Produkte sind in folgenden Literaturstellen beschrieben: Epoxyacrylate in EP-A-0 033 896, EP-A-0 049 922 und US-A-4,485,123; Urethanacrylate in EP-A-0 053 749, EP-A-0 209 684 und US-A-4,162,274; Polyesteracrylate in EP-A-0 083 666, EP-A-0 154 924 und US-A-3,968,309, Siliconacrylate in DE-A-38 10 140; DE-A-38 20 294.

Besonders bevorzugt werden durch energiereiche Strahlung härtbare Massen auf der Basis von ungesättigten Polyestern eingesetzt.

Die mit den erfindungsgemäßen flüssigen Initiatorgemischen versehenen Massen lassen sich durch energiereiche Strahlung, wie sie üblicherweise zur Härtung solcher Systeme verwendet wird, z. B. UV-Strahlung und Elektronenstrahlung, härten.

Durch die erfindungsgemäßen flüssigen Photoinitiatorgemische härtbare Massen sind beispielsweise Dentalmassen, Spachtelmassen, UP-Harzsysteme, pigmentierte Systeme, Vergußmassen, Tränkmassen und Überzugsmittel, wie durch UV-Licht härtbare Lacke.

Es hat sich gezeigt, daß die erfindungsgemäßen Photoinitiatorgemische eine wesentliche Produktionsvereinfachung durch Herabsetzung der Herstellungszeiten der zu härtenden Massen ermöglichen. Die flüssigen Gemische lassen sich rasch bereiten und können in den zu polymerisierenden Massen unproblematisch rasch gelöst werden. Die flüssigen Gemische sind häufig dauernd stabil, selbst wenn nach einiger Zeit eine Neigung zur Rückristallisation auftreten sollte, können sich die Mischungen durch einfaches Erwärmen wieder homogenisieren lassen.

Die folgenden Beispiele dienen zur Erläuterung der Erfindung.

Die folgenden Initiatormischungen wurden auf 80°C während 20 bis 30 Minuten unter Rühren bis zur Verflüssigung erwärmt Die erhaltenen Gemische konnten in flüssiger Form zum Teil bis zu einer Woche bei Raumtemperatur gelagert werden.

Der in den folgenden Initiatormischungen verwendete Photoinitiator vom Acylphosphantyp weist folgende Formel auf

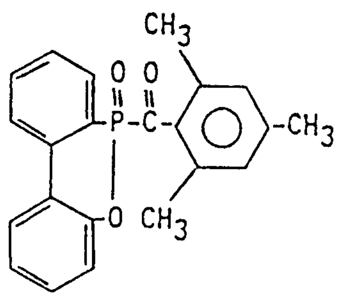

| Initiatormischung 1 | |
|---|---|
| 1-Hydroxy-cyclohexyl-phenylketon | 50,00 (fest) |
| Diphenyl-2,4,6-trimethyl-benzoyl-phosphanoxid | 50,00 (fest) |

| Initiatormischung 2 | |
|---|---|
| 1-Hydroxy-cyclohexyl-phenylketon | 50,00 (fest) |
| Photoinitiator vom cyclischen Acylphosphantyp | 50,00 (fest) |

| Initiatormischung 3 | |
|---|---|
| 2-Hydroxy-2-methyl-1-phenylpropan-1-on | 50,00 (flüssig) |
| Photoinitiator vom cyclischen Acylphosphantyp | 50,00 (fest) |

| Initiatormischung 4 | |
|---|---|
| 1-Hydroxy-2-methyl-1-phenyl-propan-2-on | 50,00 (flüssig) |
| Diphenyl-2,4,6-trimethyl-benzoyl-phosphinoxid | 50,00 (fest) |

| Initiatormischung 5 | |
|---|---|
| 1-Hydroxy-cyclohexyl-phenylketon | 33,30 (fest) |
| Photoinitiator vom cyclischen Acylphosphantyp | 33,30 (fest) |
| Benzildimethylketal | 33,40 (fest) |

| Initiatormischung 6 | |
|---|---|
| 2-Hydroxy-2-methyl-1-phenyl-propan-2-on | 33,30 (flüssig) |
| Diphenyl-2,4,6-trimethyl-benzoyl-phosphinoxid | 33,30 (fest) |
| Benzildimethylketal | 33,40 (fest) |

| Initiatormischung 7 | |
|---|---|
| 1-Hydroxy-cyclohexyl-phenylketon | 33,30 (fest) |
| Photoinitiator vom cyclischen Acylphosphantyp | 33,30 (fest) |
| Benzophenon | 33,40 (fest) |

| Initiatormischung 8 | |
|---|---|
| Diethoxyacetophenon | 50,00 (flüssig) |
| Photoinitiator vom cyclischen Acylphosphantyp | 50,00 (fest) |

| Initiatormischung 9 | |
|---|---|
| Diethoxyacetophenon<br>Photoinitiator vom cyclischen Acylphosphantyp<br>Benzophenon | 33,30 (flüssig)<br>33,30 (fest)<br>33,40 (fest) |

| Initiatormischung 10 | |
|---|---|
| Photoinitiator vom cyclischen Acylphosphantyp<br>Diphenyl-2,4,6-trimethyl-benzoyl-phosphinoxid | 50,00 (fest)<br>50,00 (fest) |

Die folgenden Lackrezepturen wurden jeweils mit den vorstehenden Initiatormischungen 1 bis 10 hergestellt. Die Initiatormischungen wurden den Lackrezepturen in flüssiger Form zugesetzt und konnten ohne Schwierigkeiten aufgelöst werden. Die erhaltenen Lacke konnten durch UV-Strahlen homogen gehärtet werden.

| Lackrezept 1 - 10 | |
|---|---|
| Epoxyacrylat (Reaktionsorpdukt von Bisphenol-A-glycidylester mit Acrylsäure<br>- TPGDA<br>- DPGDA<br>gelbes Pigment<br>Initiatormischung 1 - 10 | 75,00<br>5,00<br>10,00<br>5,00<br>5,00<br>100,00 |

| Lackrezept 11 - 20 | |
|---|---|
| Ungesättigten Polyester (handelsüblich)<br>Vinyltoluol<br>DPGDA<br>HDDA<br>Initiatorgemisch 1 - 10 | 60,00<br>20,00<br>10,00<br>7,00<br>3,00<br>100,00 |

DPGDA = Dipropylenglykoldiacrylat
TPGDA = Tripropylenglykoldiacrylat
HDDA = Hexandioldiacrylat

**Patentansprüche**

1. Flüssiges Gemisch aus zwei oder mehreren Photoinitiatoren, von denen mindestens einer ein bei Raumtemperatur fester Photoinitiator vom Acylphosphanoxidtyp ist, der durch Zusatz eines oder mehrerer bei Raumtemperatur fester Photoinitiatoren und Erwärmen und/oder durch Zusatz eines oder mehrerer bei Raumtemperatur flüssiger Photoinitiatoren und gegebenenfalls Erwärmen verflüssigt wurde.

2. Flüssiges Gemisch nach Anspruch 1, dadurch gekennzeichnet, daß es aus zwei, drei oder mehreren bei Raumtemperatur festen Photoinitiatoren besteht.

3. Flüssiges Gemisch nach Anspruch 1, dadurch gekennzeichnet, daß es aus einem, zwei oder mehreren bei Raumtemperatur festen Photoinitiatoren und mindestens einem bei Raumtemperatur flüssigen Photoinitiator besteht.

4. Flüssiges Gemisch nach einem der vorhergehenden Ansprüche, dadurch gekennzeichnet, daß es zwei

Photoinitiatoren im Verhältnis 10 : 1 bis 1 : 10 enthält.

5. Verfahren zur Herstellung eines flüssigen Gemisches von Photoinitiatoren, dadurch gekennzeichnet, daß man mindestens einen bei Raumtemperatur festen Photoinitiator vom Acylphosphanoxidtyp entweder mit mindestens einem bei Raumtemperatur festen Photoinitiator vermischt und anschließend unter Erwärmen homogenisiert, und/oder mit mindestens einem bei Raumtemperatur flüssigen Photoinitiator vermischt und homogenisiert und gegebenenfalls erwärmt.

6. Verfahren zur Polymerisation von strahlenhärtbaren Massen durch Zusatz von zwei oder mehreren Photoinitiatoren und Härtung durch Zufuhr energiereicher Strahlung, dadurch gekennzeichnet, daß man ein flüssiges Gemisch von zwei oder mehreren Photoinitiatoren nach einem der Ansprüche 1 bis 4 zusetzt.

7. Verwendung der flüssigen Gemische von zwei oder mehreren Photoinitiatoren nach einem der Ansprüche 1 bis 4 als Initiatoren bei der Photopolymerisation von strahlenhärtbaren Massen.

Europäisches Patentamt

# EUROPÄISCHER RECHERCHENBERICHT

Nummer der Anmeldung

EP 92 10 8142

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.5) |
|---|---|---|---|
| P,X | EP-A-0 446 175 (CIBA-GEIGY)<br>* Seite 4, Zeile 36 - Seite 5, Zeile 39 *<br>* Seite 2, Zeile 13 - Zeile 16 * | 1-7 | C08F2/50<br>G03F7/029 |
| D,Y | EP-A-0 057 474 (BASF)<br>* Seite 7, Zeile 30 - Seite 8, Zeile 6 *<br>& DE-A-2 909 994 | 1,3-7 | |
| Y | EP-A-0 269 573 (CIBA-GEIGY)<br>* Seite 2, Zeile 7 - Zeile 18 *<br>* Seite 10, Zeile 35 - Zeile 39 * | 1,3-7 | |
| D,A | EP-A-0 304 782 (HOECHST) | 1 | |
| D,A | EP-A-0 413 657 (CIBA-GEIGY) | 1 | |

RECHERCHIERTE SACHGEBIETE (Int. Cl.5)

C08F
G03F

Der vorliegende Recherchenbericht wurde für alle Patentansprüche erstellt

| Recherchenort | Abschlußdatum der Recherche | Prüfer |
|---|---|---|
| DEN HAAG | 04 SEPTEMBER 1992 | ANDRIOLLO G.R. |

KATEGORIE DER GENANNTEN DOKUMENTE

X : von besonderer Bedeutung allein betrachtet
Y : von besonderer Bedeutung in Verbindung mit einer anderen Veröffentlichung derselben Kategorie
A : technologischer Hintergrund
O : nichtschriftliche Offenbarung
P : Zwischenliteratur

T : der Erfindung zugrunde liegende Theorien oder Grundsätze
E : älteres Patentdokument, das jedoch erst am oder nach dem Anmeldedatum veröffentlicht worden ist
D : in der Anmeldung angeführtes Dokument
L : aus andern Gründen angeführtes Dokument

& : Mitglied der gleichen Patentfamilie, übereinstimmendes Dokument

EPO FORM 1503 03.82 (P0403)